(19) Europäisches Patentamt
European Patent Office
Office européen des brevets

(11) EP 4 455 706 A1

(12) EUROPEAN PATENT APPLICATION

(43) Date of publication:
30.10.2024 Bulletin 2024/44

(21) Application number: 23169547.9

(22) Date of filing: 24.04.2023

(51) International Patent Classification (IPC):
G01R 33/36 (2006.01)

(52) Cooperative Patent Classification (CPC):
G01R 33/3664; G01R 33/3657

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: Koninklijke Philips N.V.
5656 AG Eindhoven (NL)

(72) Inventors:
• XU, Wei
  Eindhoven (NL)

• WU, Bing
  Eindhoven (NL)
• REN, Abbott
  5656AG Eindhoven (NL)
• ZHANG, Jerry
  Eindhoven (NL)

(74) Representative: Philips Intellectual Property &
Standards
High Tech Campus 52
5656 AG Eindhoven (NL)

(54) ACQUIRING A SIGNAL WITH OVERLAPPING RECEIVE COILS FOR MR IMAGING

(57) According to the invention, a method for selecting a set of coil elements of a radio frequency coil system (2) with a plurality of coil elements (4) for receiving magnetic resonance signals of a region of interest, the method comprising the following method steps:
determining a signal to noise ranking of the plurality of coil elements (4) for the region of interest;
assigning the coil elements (4) to a first type A and a second type B based on the determined signal to noise ranking, wherein coil elements with a signal-to-noise ratio higher than a predetermined threshold are assigned to type A and coil elements with a signal-to-noise ratio lower than a predetermined threshold are assigned to type B;
determining a coupling effect of each coil element (4) of the radio frequency coil system (2) for the region of interest;
grouping the coil elements (4) assigned to the first type A or to the second type B into a primary coil group (8) and a secondary coil group (9) based on the determined coupling effect and the signal-to-noise ratio, wherein coil elements (4) with mutual coupling effect with each other are at least partially allocated into different coil groups (8, 9); and
selecting the coil elements either of the primary coil group (8) or of the secondary coil group (9) for receiving the magnetic resonance signals of the region of interest.
In this way, the quality of MR imaging can be improved while avoiding a simple exclusion of coil elements (4) that do not deliver enough information content but by selecting and combining coil elements (4) so that the maximum possible number of coil elements (4) are used for receiving the electromagnetic induction signal while increasing the SNR.

Fig. 2

**Description**

FIELD OF THE INVENTION

The invention relates to the field of magnetic resonance (MR) imaging, and in particular to a method for acquiring an electromagnetic induction signal with one or more overlapping receive coils.

BACKGROUND OF THE INVENTION

In magnetic resonance imaging, various receive coils are used to receive electromagnetic induction signals. After converting these electromagnetic induction signals into digital signals using an analog-to-digital conversion module, various images used for diagnosis are reconstructed.

Magnetic resonance imaging has a wide range of clinical applications when used for acquisition of various parts of the body. Subsequently, there are various receive coils for the reception. With the developments of magnetic resonance applications, there are more and more clinical cases in which two or more receive coils are used simultaneously or the same flexible receive coil is used in different anatomies. In these clinical scenarios of using receive coils, there is always an overlap between channels in the coil or between several coils, which will cause coupling and decrease the signal-to-noise ratio (SNR). Therefore, the quality of imaging decreases. Magnetic resonance acquisition is usually performed by means of multiple averaging accumulations to improve the signal-to-noise ratio (SNR), especially when the main magnetic field is relatively low, for example less than or equal to 1.5 T or when the imaging field of view is relatively small.

In traditional scanning, the same coil elements combination which has coupling effects among overlapped coil elements is used in different acquisition stages of multiple averaging acquisition, this will cause a decrease of the SNR. "Coupling effects among overlapped coil elements" means that two coil elements are arranged relative to another so that coupling effects that lead to degraded image quality are created between those two coil elements. This is the case if these two coil elements overlap geometrically or are arranged very close to another. An overlap can be present between two coil elements of two different stiff receive coils or of the same flexible receive coil.

This traditional acquisition strategy causes an inaccurate result because the channels with a low SNR are simply removed or the channels with overlapping channels are either simply not used or are used completely with the same weighting. These strategies also applied for channels with coupling of flexible coil. In the acquisition stage, only the same coil elements combination mode is used. These traditional acquisition strategies neither fully utilize the available receive channels nor completely address the coupling effect between some of the utilized channels.

US 2011/006 766 A1 describes a method for selecting a set of coil elements from a multitude of physical coil elements comprised in a coil array for performing a magnetic resonance imaging scan. The coil elements are ranked dependent on a noise sensitivity matrix and on a calculated information content. According to this ranking, the most suitable set of coil elements are selected.

SUMMARY OF THE INVENTION

It is an object of the invention to improve the quality of MR imaging while avoiding a simple exclusion of coil elements that do not deliver enough information content but by selecting and combining coil elements so that the maximum possible number of coil elements are used for receiving the electromagnetic induction signal while increasing the SNR.

According to the invention, this object is addressed by the subject matter of the independent claims. Preferred embodiments of the invention are described in the sub claims.

Therefore, according to the invention, a method for selecting a set of coil elements of a radio frequency coil system with a plurality of coil elements for receiving magnetic resonance signals of a region of interest is provided, wherein the method comprises the following steps:

determining a signal to noise ranking of the plurality of coil elements (4) for the region of interest;
assigning the coil elements (4) to a first type A and a second type B based on the determined signal to noise ranking, wherein coil elements with a signal-to-noise ratio higher than a predetermined threshold are assigned to type A and coil elements with a signal-to-noise ratio lower than a predetermined threshold are assigned to type B;
determining a coupling effect of each coil element (4) of the radio frequency coil system (2) for the region of interest;
grouping the coil elements (4) assigned to the first type A or to the second type B into a primary coil group (8) and a secondary coil group (9) based on the determined coupling effect and the signal-to-noise ratio, wherein coil elements (4) with mutual coupling effect with each other are at least partially allocated into different coil groups (8, 9); and

selecting the coil elements either of the primary coil group (8) or of the secondary coil group (9) for receiving the magnetic resonance signals of the region of interest.

As explained further above, it is important to group and combine the coil elements to ensure receiving an electromagnetic induction signal with the highest possible SNR and the maximum possible number of coil elements. In particular, a coil element corresponds to a coil channel.

When two or more receiving coils are used to receive data at the same time, all the coil elements that can be used for receiving are classified into two types. Coil elements with a higher SNR are assigned to type A and coil elements with a lower SNR are assigned to type B. According to both types A and B, the coil elements are divided into two groups, namely primary coil group and secondary coil group.

It is an essential point of the invention that coil elements with mutual coupling effect with each other are at least partially allocated into different coil groups and are therefore divided.

A signal to noise ranking means arranging all coil elements according to its contribution to the SNR, namely from a higher contribution to the SNR to a lower contribution to the SNR. These coil elements are assigned by means of the predetermined threshold into a type A with a higher contribution to the SNR and a type B with a lower contribution to the SNR.

Generally, the mutual coupling is between two overlapped elements so that the dividing method can make sure that in each group, a coupling effect between two overlapped coil elements within the same group is significantly decreased or even totally eliminated.

In particular, a noise correlation matrix and/or a coil sensitivity map are used to determine whether two coil elements have coupling effects between each other.

According to a preferred embodiment of the invention, the method comprises the further method steps:

allocating coil elements of type A without a coupling effect, coil elements of type B without a coupling effect and coil elements of type A coupled with coil elements of type B into the primary coil group,

allocating coil elements of type A without a coupling effect, coil elements of type B without a coupling effect and coil elements of type B coupled with coil elements of type A into the secondary coil group; and

allocating two coil elements of the same type A or B with a mutual coupling effect into different coil groups according to the signal-to-noise ratio, wherein the coil element with the higher signal-to-noise ratio is allocated in the primary coil group and the coil element with the lower signal-to-noise ratio is allocated in the secondary coil group.

The primary coil group comprises coil elements of type A more specifically channels for coils that contribute relatively more to the SNR, and the secondary coil group comprises coil elements of type B more specifically channels for coils that contribute relatively less to the SNR. At the same time, coil elements that have coupling effects with other elements are also marked. Coil elements that comprise a mutual coupling effect within the same group are divided. Thereby, a first coil element and a second coil element of the coil elements with a mutual coupling effect within the same group are determined. The first coil element comprises a higher SNR than the second coil element. The first coil element is allocated in the primary coil group and the second coil element is allocated in the secondary coil group.

"Allocated" means preferably, that coil elements are moved from its original group to the respective other group. For example, if two coil elements within the primary coil group comprise a mutual coupling effect, the coil element with the higher SNR is left in the primary coil group and the second coil element is moved to the secondary coil group. In this way, coil elements with a mutual coupling effect are divided into different groups and used for different scans. Channels for coils that do not comprise a coupling effect are grouped into both coil groups, namely into primary coil group and into secondary coil group.

As a result, two coil groups, namely the primary coil group and the secondary coil group, are built. The primary coil group comprises coil elements with a SNR higher than the predetermined threshold thus with a higher contribution to the SNR (coil elements of type A) and coil elements without a coupling effect of type A and type B. The secondary coil group comprises coil elements with a SNR lower than the predetermined threshold and thus with a lower contribution to the SNR (coil elements of type B) and also the coil elements without coupling of type A and type B. Coil elements of the primary coil group that comprise a coupling effect with a coil element of the secondary coil group are not problematic, because the coil elements of different groups are used separately for different scans. Coil elements with a mutual coupling effect within the same coil group, for example two coil elements with a mutual coupling effect that are both grouped into the primary coil group, are divided into different coil groups by allocating or rearranging the coil element with the higher signal-to-noise ratio in the primary coil group and the coil element with the lower signal-to-noise ratio in the secondary coil group, as explained above.

Preferably, the method comprises further the method step of pre-scanning the region of interest to determine the signal to noise ranking and the coupling effect.

With the generated pre-scan data of the pre-scanning the coil elements are analyzed once per arrangement of the receiving coils before the actual MRI scan is started. Based on the pre-scan data the coil channels are grouped and divided into two groups, the primary coil group and the secondary coil group. Preferably, in the later MRI scan a part of acquisition uses the coil elements of the primary coil group and another part of acquisition uses the coil elements of the secondary coil group, which minimizes the impact of coupling among channels.

According to a preferred embodiment of the invention, the radio frequency coil system comprises at least one flexible receive coil or at least two stiff receive coils, wherein each receive coil comprises several coil elements and at least two coil elements are arranged during a magnetic resonance imaging scan such that they overlap one another at least partially.

The coil system comprises multiple coils used in combination or a single flexible coil. "Overlapping partially" means that two coil elements are arranged relative to another so that coupling effects that lead to degraded image quality are created between those two overlapped coil elements. This is the case if these two coil elements overlap geometrically or are arranged very close to another. An overlap can be present between two coil elements of two different stiff receive coils or of the same flexible receive coil.

According to a preferred embodiment of the invention, the method comprises the following further method steps:

removing the coil elements with a signal-to-noise ratio lower than a second predetermined threshold based on the determined signal-to noise ranking;
grouping the remaining coil elements as described above.

In particular, removing means ignoring the coil elements for receiving magnetic resonance signals. Coil elements with a SNR lower than a SNR limit threshold respectively the second threshold are completely removed. Then, all coil elements that can be used for receiving are divided into two groups, the primary coil group and secondary coil group, based on the contribution to the SNR and coupling effects. In particular, the second threshold is lower than the first predetermined threshold for dividing the coil elements into two groups.

According to a preferred embodiment of the invention, three or more coil elements of the same type A or B with a mutual coupling effect are partially allocated into different groups according to the signal-to-noise ratio. Thereby, the coil element with the highest signal-to-noise ratio is allocated in the primary coil group, the coil element with the second highest signal-to-noise ratio is allocated in the secondary coil group and the coil element or coil elements with a lower signal-to-noise ratio are removed.

In some cases, for example while using very large flexible coils for a small anatomy and because of folding or blending the receiving coil into several layers or while using two or more receiving coil simultaneously, there may be three or more coupling loops existing in the same coil group. Then, the element with the highest SNR of the primary coil group is left in the primary coil group, but the coil element with the second highest SNR is moved to the secondary coil group. Simultaneously, the coil element with the highest SNR of the secondary coil group is moved into the primary coil group and the coil element with the second highest SNR of the secondary coil group is left in the secondary coil group. The remaining coil elements with a mutual coupling effect within the same group are removed and are not used for scanning. As a result, a mutual coupling effect induced by overlapped coil elements within the same group is totally eliminated and the quality of scanning is further increased.

According to a preferred embodiment of the invention, the method comprises the following further method steps:

if the number of signal acquisitions is one, then selecting the coil elements of the primary coil group for receiving the electromagnetic induction signal during the magnetic resonance imaging scan,
if the number of signal acquisitions is higher than one, then selecting the coil elements of the primary coil group for a first acquisition and the coil elements of the secondary coil group for a second acquisition different from the first acquisition for receiving the electromagnetic induction signal during the magnetic resonance imaging scan.

This new acquisition strategy allocates the acquisition of multiple average accumulations to the primary coil group and the secondary coil group and ensure that if the number of acquisition (NSA) is only 1, the coil elements of the primary coil group are used for receiving the electromagnetic induction signal during the magnetic resonance imaging scan, and if the number of acquisition is more than 1, the coil elements of the primary coil group are used for the first acquisition and the coil elements of the secondary coil group are used for the second acquisition for receiving the electromagnetic induction signal during the magnetic resonance imaging scan. In this way, the coil elements of the different coil groups are used separately for receiving the signal so that coupling effects with each other can be avoided.

According to a preferred embodiment of the invention, the method comprises the following further method steps:

if the number of signal acquisitions is higher than one and odd, then selecting the coil elements of the primary coil group and of the secondary coil group for receiving the electromagnetic induction signal, wherein the signal is received from coil elements of the primary coil group for one more acquisition than from secondary coil group,

if the number of signal acquisitions is higher than one and not odd, then selecting the coil elements of the primary coil group and of the secondary coil group each for half the number of signal acquisition for receiving the electromagnetic induction signal.

In this way, if the number of signal acquisitions is more than or equal to two times, the number of acquisition time uses the primary coil group is equal to the number of acquisitions which uses the secondary coil group, or one more time when uses the primary coil group. Compared to the traditional cumulative average acquisition, there will be no increase in the total scanning time using the proposed strategy. But it eliminates the mutual coupling effect caused by the physical overlap between channels due to the simultaneous usage of multiple coils or single flexible coils with part of its channels overlapped. This will improve the signal-to-noise ratio.

The number of signal acquisition (NSA) is divided into two parts, namely one part using the primary coil group for receiving the signal (NP) and one part using the secondary coil group for receiving the signal (NS):

$$\mathrm{NSA} = \mathrm{NP} + \mathrm{NS}.$$

The coil elements of primary coil group are used for one part NP according to the following formula:

$$\mathrm{NP} = \frac{\mathrm{NSA}-1}{2} + 1.$$

The coil elements of secondary coil group are used for the other part NS according to the following formula:

$$\mathrm{NS} = \frac{\mathrm{NSA}-1}{2}.$$

Further, according to the invention, a magnetic resonance imaging system is provided that comprises

a radio frequency coil system with a plurality of coil elements for receiving magnetic resonance signals of a region of interest;
a radio frequency coil system with a plurality of coil elements for receiving magnetic resonance signals of a region of interest;
an evaluation unit adapted to determine a signal-to-noise ranking for the plurality of coil elements for the region of interest and to determine a coupling effect of each coil element of the radio frequency coil system for the region of interest,
the evaluation unit further adapted to group the coil elements into a type A and a type B based on the determined signal-to-noise ranking, wherein coil elements with a signal-to-noise ratio higher than a predetermined threshold are grouped into type A and coil elements with a signal-to-noise ratio lower than a predetermined threshold are grouped into type B,
the evaluation unit further adapted to group the coil elements assigned to the first type A or to the second type B into a primary coil group and a secondary coil group based on the determined coupling effect and the signal-to-noise ratio, wherein coil elements with mutual coupling effect with each other are allocated into different coil groups,
a control unit adapted to select the coil elements either of the primary coil group or of the secondary coil group for receiving the magnetic resonance signals of the region of interest.

The radio frequency coil system comprises an evaluation unit and a control unit that are adapted to group the coil elements according to the SNR ranking and to select the coil elements of the respective groups for receiving the magnetic resonance signal as stated above.

According to a preferred embodiment of the invention, the evaluation unit is further adapted to allocate coil elements of type A without a coupling effect, coil elements of type B without a coupling effect and coil elements of type A coupled with coil elements of type B into the primary coil group,

to allocate coil elements of type A without a coupling effect, coil elements of type B without a coupling effect and coil elements of type B coupled with coil elements of type A into the secondary coil group; and
to allocate two coil elements of the same type A or B with a mutual coupling effect into different coil groups according to the signal-to-noise ratio, wherein the coil element with the higher signal-to-noise ratio is allocated in the primary coil group and the coil element with the lower signal-to-noise ratio is allocated in the secondary coil group.

Preferably, the control unit is further adapted to pre-scan the region of interest to determine the signal to noise ranking and the couple effect.

According to a preferred embodiment of the invention, the radio frequency coil system comprises at least one flexible receive coil or at least two stiff receive coils, wherein each receive coil comprises several coil elements and at least two coil elements are arranged during a magnetic resonance imaging scan such that they overlap one another at least partially.

According to a preferred embodiment of the invention, the evaluation unit is further adapted to remove the coil elements with a signal-to-noise ratio lower than a second predetermined threshold based on the determined signal-to-noise ranking and to group the remaining coils as explained above.

Therefore, the evaluation unit can pre-scan the coil elements, rank them according to its SNR, remove the coil elements with a signal-to-noise ratio lower than a second predetermined threshold and group them into the primary coil group and secondary coil group. After that, the control unit can select the coil elements of the respective groups for receiving the magnetic resonance signal.

According to a preferred embodiment of the invention, the evaluation unit is further adapted to group the coil elements into a primary coil group and a secondary coil group based on the determined signal to noise ranking and coupling effect, wherein three or more coil elements with a mutual coupling effect within the same group are partially allocated into different groups according to the signal-to-noise ratio, wherein the coil element with the highest signal-to-noise ratio is allocated in the primary coil group, the coil element with the second highest signal-to-noise ratio is allocated in the secondary coil group and the coil element or coil elements with a lower signal-to-noise ratio are removed.

According to a preferred embodiment of the invention, the control unit is adapted to select the coil elements of the primary coil group for receiving the electromagnetic induction signal during the magnetic resonance imaging scan if the number of signal acquisitions is one, and to select the coil elements of the primary coil group for a first acquisition and the coil elements of the secondary coil group for a second acquisition different from the first acquisition for receiving the electromagnetic induction signal during the magnetic resonance imaging scan if the number of signal acquisitions is higher than one.

According to a preferred embodiment of the invention, the control unit is adapted to select the coil elements of the primary coil group and of the secondary coil group for receiving the electromagnetic induction signal if the number of signal acquisitions is higher than one and odd, wherein the signal is received from coil elements of the primary coil group for one more acquisition than from secondary coil group, and to select the coil elements of the primary coil group and of the secondary coil group each for half the number of signal acquisition for receiving the electromagnetic induction signal if the number of signal acquisitions is higher than one and not odd.

In the data acquisition of magnetic resonance, the signal average is usually used to improve the SNR. According to the preferred embodiments of the invention stated above, the acquisition strategy allocates the acquisition of multiple average accumulations to the primary coil group and the secondary coil group and ensure that when the number of acquisition is only 1, the primary coil group is used, and when the number of accumulations is more than or equal to 2 times, the number of acquisition time uses the primary coil group is equal to the number of acquisition which uses the secondary coil group, or one more time when uses the primary coil group. Compared to the traditional cumulative average acquisition, there is not an increase in the total scanning time using the proposed strategy, but rather eliminates the mutual coupling effect caused by the physical overlap between channels due to the simultaneous usage of multiple coils or single flexible coils with part of its channels overlapped. Therefore, the signal-to-noise ratio can be improved.

Further, according to the invention, a non-transitory computer-readable medium is provided that comprises instructions stored thereon, that when executed on a processor induce a radio frequency receiver system for an MRI apparatus to perform a method stated above.

BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:

Fig. 1 schematically depicts a magnetic resonance imaging system according to a preferred embodiment of the invention;
Fig. 2 schematically depicts a process scheme of grouping the coil elements to a preferred embodiment of the invention;
Fig. 3 schematically depicts a method for receiving an electromagnetic induction signal with a radio frequency receiver system according to a preferred embodiment of the invention.

DETAILED DESCRIPTION OF EMBODIMENTS

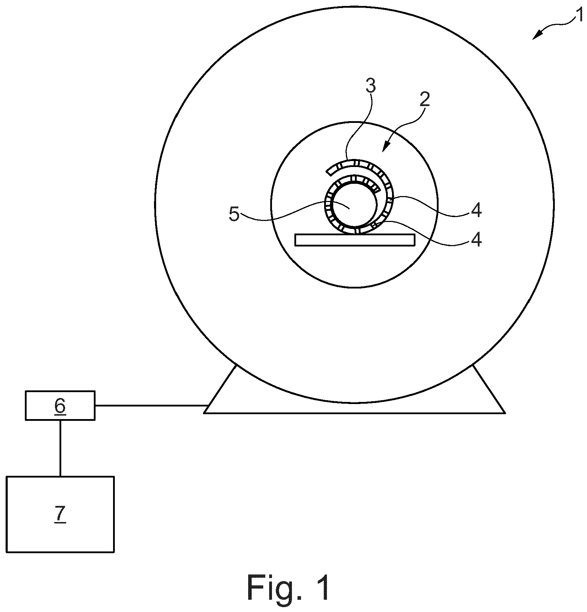

Fig. 1 schematically depicts a magnetic resonance imaging system 1 according to a preferred embodiment of the invention. The magnetic resonance imaging system 1 comprises an MRI apparatus. An examination object 5 is arranged within the MRI apparatus. For the MRI-scan the examination object is covered with a receive coil 3 of a radio frequency receiver system 2. The receive coil 3 is flexible and wrapped around the examination object 5 so that the coil elements 4 of the receive coil 3 overlap partially. To avoid coupling effects and improve the SNR and quality of the MRI scan, the evaluation unit 7 and the control unit 6 are adapted to group the coil elements according to the concrete position of the receive coil 3.

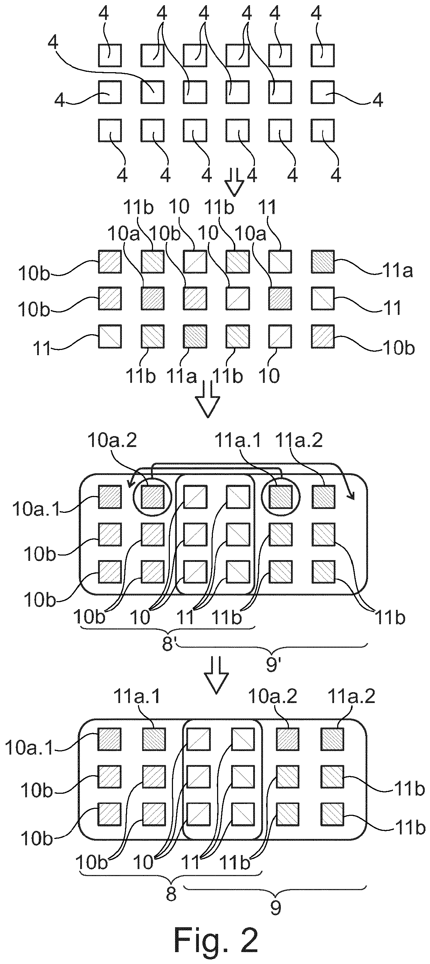

Fig. 2 schematically depicts a grouping scheme of coil elements 4, in particular of a single flexible coil 3 with overlapping parts is used as shown in Fig. 1. In a first step there exists several coil elements 4 either of the same partially overlapping receive coil or of different receive that are arranged so that they partially overlap. In a next step, the coil elements 4 are ranked according to the contribution to the SNR and then are classified into a type A and a type B. Type A coil elements comprise a higher contribution to the SNR and type B coil elements comprise a lower contribution to the SNR. Further, coupling effects of the coil elements are determined. There exist coil elements of type A without a coupling effect 10, coil elements of type A with a coupling effect of the same type 10a and coil elements of type A with a coupling effect of the other type 10b. Similarly, there exist coil elements of type B without a coupling effect 11, coil elements of type B with a coupling effect of the same type 11a and coil elements of type B with a coupling effect of the other type 11b. According to the determined coupling effects, in a next step, the coil elements are grouped into an intermediate primary coil group 8' and an intermediate secondary coil group 9'. If the contribution to the SNR is higher than a predetermined threshold (type A), the coil elements 10, 10a, 10b are grouped to the intermediate primary coil group 8'. If the contribution to the SNR is lower than the predetermined threshold (type B), the coil element 11, 11a, 11b are grouped to the intermediate secondary coil group 9'. The coil elements without a coupling effect 10, 11 are grouped in the intermediate primary coil groups 8' and in the intermediate secondary coil group 9'. Fig. 2 shows that the intermediate primary coil group 8' and the intermediate secondary coil group 9' overlap and that both comprise the coil elements without any coupling effects 10, 11.

In some cases, for example while using very large flexible coils for a small anatomy and because of folding or blending the receiving coil into several layers or while using two or more receiving coil simultaneously, there may be two or more coupling loops existing in the same coil group. Then in the next step, by this "marked coupling", for elements with mutual coupling 10a in the intermediate primary coil group 8', combined with SNR ranking, the top two elements 10a.1, 10a.2 are selected, the coil element with higher SNR 10a. 1 is left in the intermediate primary coil group 8', and the other 10a.2 is moved to the intermediate secondary coil group 9'. Same as the principle, for elements with mutual coupling 11a in the intermediate secondary coil group 9', combined with SNR ranking, the top two elements 11a.1, 11a.2 are selected, the element with lower SNR 11a.2 is left in the intermediate secondary coil group 9', and the other 11a.1 is moved to the intermediate primary coil group 8'. As a result, a mutual coupling effect no longer exists in either the final primary coil group 8 or the final secondary coil group 9. If the number of coupling loops is higher than two, the coil elements with mutual coupling with a lower SNR than the second highest SNR are removed (not shown) to totally remove the coupling effect within each of the primary and secondary groups. Alternatively, the coil elements with mutual coupling with a lower SNR than the second highest SNR can also be left in the group since the two coil elements with higher contribution to the SNR have been allocated into different groups and such allocation of the partial two coil elements with higher signal-to-noise ratio has significantly reduced the coupling effect within each of the primary and secondary groups. As a result, the coil elements with a higher contribution to the SNR and therefore with a higher importance, that comprise mutual coupling effects within the same group are divided. Therefore, if the mutual coupling exists between two coil elements, this moving-out step ensures mutual coupling within the primary or secondary coil group does not exist anymore. If mutual coupling exists between more than two channels, the moving-out step also minimizes the coupling within the primary or secondary coil group and also achieve a better SNR.

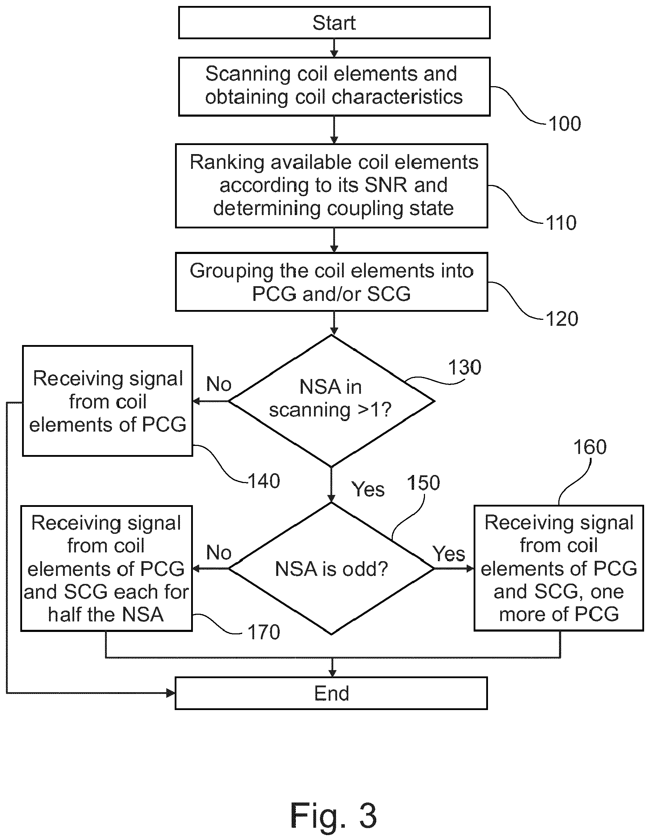

Fig. 3 schematically depicts a method for receiving an electromagnetic induction signal with a radio frequency receiver system according to a preferred embodiment of the invention.

In a first step 100 the coil elements 4 of the receive coil 3 are scanned. With these pre-scan date the coil characteristics, namely the contribution to the SNR and the coupling state, are obtained. In the next step 110 the coil elements 4 are ranked according to the SNR and the coupling state. Afterwards in step 120, the coil elements 4 are grouped in the primary coil group 8 and in the secondary coil group 9 as shown in Fig. 2.

For the MRI scan, it is checked in step 130 whether the number of acquisitions is higher than one. If no, the MRI signal is received from coil elements of the primary coil group 140. If yes, it is checked whether the number of acquisitions is odd 150. If no, the MRI signal is received from coil elements of the primary coil group and of the secondary coil group each for half the number of acquisitions 170. If yes, the MRI signal is received from coil elements of the primary coil group and of the secondary coil group one time more of the primary coil group 160.

As a result, the maximum possible number of coil elements are used for receiving the electromagnetic induction signal while increasing the SNR.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

REFERENCE SYMBOL LIST

| | |
|---|---|
| magnetic resonance imaging system | 1 |
| radio frequency receiver system | 2 |
| receive coil | 3 |
| coil element | 4 |
| examination object | 5 |
| control unit | 6 |
| evaluation unit | 7 |
| primary coil group (PCG) | 8 |
| intermediate primary coil group | 8' |
| secondary coil group (SCG) | 9 |
| intermediate secondary coil group | 9' |
| coil element of type A, without coupling | 10 |
| coil element of type A, with coupling with type A | 10a |
| coil element of type A, with coupling with type B | 10b |
| coil element of type A, with coupling with type A and highest SNR | 10a.1 |
| coil element of type A, with coupling with type A and 2$^{nd}$ highest SNR | 10a.2 |
| coil element of type B, without coupling | 11 |
| coil element of type B, with coupling with type B | 11a |
| coil element of type B, with coupling with type A | 11b |
| coil element of type B, with coupling with type B and highest SNR | 11a.1 |
| coil element of type B, with coupling with type B and 2$^{nd}$ highest SNR | 11a.2 |
| scanning coil elements | 100 |
| ranking coil elements according to its SNR and determining a coupling state | 110 |
| grouping coil element into PCG and/or SCG | 120 |
| determining the number of signal acquisitions (NSA) | 130 |
| receiving signal from coil elements of PCG | 140 |
| determining whether NSA is odd | 150 |
| receiving signal from coil elements of PCG and SCG, with one more of PCG | 160 |
| receiving signal from coil elements of PCG and SCG, each for half the NSA | 170 |

**Claims**

1.  Method for selecting a set of coil elements of a radio frequency coil system (2) with a plurality of coil elements (4) for receiving magnetic resonance signals of a region of interest, the method comprising the following method steps:

determining a signal to noise ranking of the plurality of coil elements (4) for the region of interest;

assigning the coil elements (4) to a first type A and a second type B based on the determined signal to noise ranking, wherein coil elements with a signal-to-noise ratio higher than a predetermined threshold are assigned to type A and coil elements with a signal-to-noise ratio lower than a predetermined threshold are assigned to type B;

determining a coupling effect of each coil element (4) of the radio frequency coil system (2) for the region of interest;

grouping the coil elements (4) assigned to the first type A or to the second type B into a primary coil group (8) and a secondary coil group (9) based on the determined coupling effect and the signal-to-noise ratio, wherein coil elements (4) with mutual coupling effect with each other are at least partially allocated into different coil groups (8, 9); and

selecting the coil elements either of the primary coil group (8) or of the secondary coil group (9) for receiving the magnetic resonance signals of the region of interest.

2. Method of any of claim 1 further comprising:

allocating coil elements of type A without a coupling effect (10), coil elements of type B without a coupling effect (11) and coil elements of type A coupled with coil elements of type B (10b) into the primary coil group (8),

allocating coil elements of type A without a coupling effect (10), coil elements of type B without a coupling effect (11) and coil elements of type B coupled with coil elements of type A (11b) into the secondary coil group (9); and

allocating two coil elements of the same type A or B with a mutual coupling effect (10a, 11a) into different coil groups (8, 9) according to the signal-to-noise ratio, wherein the coil element with the higher signal-to-noise ratio (10a.1, 11a.1) is allocated in the primary coil group (8) and the coil element with the lower signal-to-noise ratio (10a.2, 11a2) is allocated in the secondary coil group (9).

3. Method of claim 1 or 2, wherein the radio frequency coil system (2) comprises at least one flexible receive coil (3) or at least two stiff receive coils, wherein each receive coil comprises several coil elements (4) and at least two coil elements (4) are arranged during a magnetic resonance imaging scan such that they overlap one another at least partially.

4. Method of any of claims 1 to 3, with the following further method steps:

removing the coil elements with a signal-to-noise ratio lower than a second predetermined threshold based on the determined signal-to noise ranking;

grouping the remaining coil elements according to claim 1.

5. Method of any of claims 1 to 4, wherein three or more coil elements of the same type A or B with a mutual coupling effect are partially allocated into different groups according to the signal-to-noise ratio, wherein the coil element with the highest signal-to-noise ratio (10a.1, 11a.1) is allocated in the primary coil group (8), the coil element with the second highest signal-to-noise ratio (10a.2, 11a2) is allocated in the secondary coil group (9) and the coil element or coil elements with a lower signal-to-noise ratio are removed.

6. Method of any of claims 1 to 5, wherein

if the number of signal acquisitions is one, then selecting the coil elements of the primary coil group (8) for receiving the electromagnetic induction signal during the magnetic resonance imaging scan,

if the number of signal acquisitions is higher than one, then selecting the coil elements of the primary coil group (8) for a first acquisition and the coil elements of the secondary coil group (9) for a second acquisition different from the first acquisition for receiving the electromagnetic induction signal during the magnetic resonance imaging scan.

7. Method of any of claims 1 to 6, wherein

if the number of signal acquisitions is higher than one and odd, then selecting the coil elements of the primary coil group (8) and of the secondary coil group (9) for receiving the electromagnetic induction signal, wherein the signal is received from coil elements of the primary coil group (8) for one more acquisition than from secondary coil group (9),
if the number of signal acquisitions is higher than one and not odd, then selecting the coil elements of the primary coil group (8) and of the secondary coil group (9) each for half the number of signal acquisition for receiving the electromagnetic induction signal.

8. A magnetic resonance imaging system (1) comprising

a radio frequency coil system (2) with a plurality of coil elements (4) for receiving magnetic resonance signals of a region of interest;
an evaluation unit (7) adapted to determine a signal-to-noise ranking for the plurality of coil elements (4) for the region of interest and to determine a coupling effect of each coil element (4) of the radio frequency coil system (2) for the region of interest,
the evaluation unit (7) further adapted to assign the coil elements (4) into a type A and a type B based on the determined signal-to-noise ranking, wherein coil elements with a signal-to-noise ratio higher than a predetermined threshold are assigned into type A and coil elements with a signal-to-noise ratio lower than a predetermined threshold are assigned into type B,
the evaluation unit (7) further adapted to group the coil elements (4) assigned to the first type A or to the second type B into a primary coil group (8) and a secondary coil group (9) based on the determined coupling effect and the signal-to-noise ratio, wherein coil elements (4) with mutual coupling effect with each other are at least partially allocated into different coil groups (8, 9),
a control unit (6) adapted to select the coil elements (4) either of the primary coil group (8) or of the secondary coil group (9) for receiving the magnetic resonance signals of the region of interest.

9. The magnetic resonance imaging system (1) of claim 8, wherein

the evaluation unit (7) is further adapted to allocate coil elements of type A without a coupling effect (10), coil elements of type B without a coupling effect (11) and coil elements of type A coupled with coil elements of type B (10b) into the primary coil group (8),
to allocate coil elements of type A without a coupling effect (10), coil elements of type B without a coupling effect (11) and coil elements of type B coupled with coil elements of type A (11b) into the secondary coil group (9); and
to allocate two coil elements of the same type A or B with a mutual coupling effect (10a, 11a) into different coil groups (8, 9) according to the signal-to-noise ratio, wherein the coil element with the higher signal-to-noise ratio (10a.1, 11a.1) is allocated in the primary coil group (8) and the coil element with the lower signal-to-noise ratio (10a.2, 11a2) is allocated in the secondary coil group (9).

10. The magnetic resonance imaging system (1) of claims 8 or 9, wherein the radio frequency coil system (2) comprises at least one flexible receive coil (3) or at least two stiff receive coils, wherein each receive coil comprises several coil elements (4) and at least two coil elements (4) are arranged during a magnetic resonance imaging scan such that they overlap one another at least partially.

11. The magnetic resonance imaging system (1) of any of claim 8 to 10, wherein the evaluation unit (7) is further adapted to remove the coil elements with a signal-to-noise ratio lower than a second predetermined threshold based on the determined signal-to noise ranking and to group the remaining coils according to claim 8.

12. The magnetic resonance imaging system (1) of any of claim 8 to 11, wherein the evaluation unit (7) is further adapted to group the coil elements (4) into a primary coil group (8) and a secondary coil group (9) based on the determined signal to noise ranking and coupling effect, wherein three or more coil elements with a mutual coupling effect within the same group are partially allocated into different groups according to the signal-to-noise ratio, wherein the coil element with the highest signal-to-noise ratio (10a.1, 11a.1) is allocated in the primary coil group (8), the coil element with the second highest signal-to-noise ratio (10a.2, 11a2) is allocated in the secondary coil group (9) and the coil element or coil elements with a lower signal-to-noise ratio are removed.

13. The magnetic resonance imaging system (1) of any of claims 8 to 12, wherein the control unit (6) is adapted to select the coil elements (4) of the primary coil group (8) for receiving the electromagnetic induction signal during the magnetic resonance imaging scan if the number of signal acquisitions is one, and to select the coil elements (4) of the primary coil group (8) for a first acquisition and the coil elements (4) of the secondary coil group (9) for a second acquisition different from the first acquisition for receiving the electromagnetic induction signal during the magnetic resonance imaging scan if the number of signal acquisitions is higher than one.

**14.** The magnetic resonance imaging system (1) of any of claims 8 to 13, wherein the control unit (6) is adapted to select the coil elements (4) of the primary coil group (8) and of the secondary coil group (9) for receiving the electromagnetic induction signal if the number of signal acquisitions is higher than one and odd, wherein the signal is received from coil elements (4) of the primary coil group (8) for one more acquisition than from secondary coil group (9), and to select the coil elements (4) of the primary coil group (8) and of the secondary coil group (9) each for half the number of signal acquisition for receiving the electromagnetic induction signal if the number of signal acquisitions is higher than one and not odd.

**15.** A non-transitory computer-readable medium, comprising instructions stored thereon, that when executed on a processor induce a radio frequency receiver system (2) for an MRI apparatus to perform a method according to any of claims 1 to 7.

Fig. 1

Fig. 2

```
                    ┌─────────────────────────┐
                    │          Start          │
                    └────────────┬────────────┘
                                 │
                    ┌────────────▼────────────┐
                    │  Scanning coil elements  │
                    │  and obtaining coil      │
                    │  characteristics         │──── 100
                    └────────────┬────────────┘
                                 │
                    ┌────────────▼────────────┐
                    │  Ranking available coil  │
                    │  elements according to   │
                    │  its SNR and determining │──── 110
                    │  coupling state          │
                    └────────────┬────────────┘
                                 │
                    ┌────────────▼────────────┐
                    │  Grouping the coil       │
                    │  elements into PCG       │──── 120
                    │  and/or SCG              │
                    └────────────┬────────────┘
```

Receiving signal from coil elements of PCG ◄── No ── NSA in scanning >1? ── 130

140

150 160

Yes

Receiving signal from coil elements of PCG and SCG each for half the NSA ◄── No ── NSA is odd? ── Yes ──► Receiving signal from coil elements of PCG and SCG, one more of PCG

170

End

# Fig. 3

Europäisches
Patentamt

European
Patent Office

Office européen
des brevets

# EUROPEAN SEARCH REPORT

Application Number

EP 23 16 9547

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MARIYA DONEVA ET AL: "Automatic coil selection for channel reduction in SENSE-based parallel imaging", MAGNETIC RESONANCE MATERIALS IN PHYSICS, BIOLOGY AND MEDICINE, CHAPMAN AND HALL, LONDON, GB, vol. 21, no. 3, 3 April 2008 (2008-04-03), pages 187-196, XP019596838, ISSN: 1352-8661 * SNR-based coil selection with sequential backward elimination search *; pages 189-191 ----- | 1-15 | INV. G01R33/36 |
| X,D | US 2011/006766 A1 (JURRISSEN MICHEL PAUL JURRIAAN [NL] ET AL) 13 January 2011 (2011-01-13) * paragraph [0039] - paragraph [0041] * ----- | 1-15 | |
| A | US 2017/045599 A1 (CAULEY STEPHEN [US] ET AL) 16 February 2017 (2017-02-16) * paragraph [0022]; figure 2 * ----- | 1-15 | |
| A | US 2017/234948 A1 (HUANG LUWEI [NL]) 17 August 2017 (2017-08-17) * claim 14 * ----- | 1-15 | TECHNICAL FIELDS SEARCHED (IPC) G01R |
| A | US 2012/172704 A1 (PIRON CAMERON ANTHONY [CA] ET AL) 5 July 2012 (2012-07-05) * paragraphs [0115] - [0116] * ----- | 1-15 | |

The present search report has been drawn up for all claims

| Place of search | Date of completion of the search | Examiner |
|---|---|---|
| Munich | 25 September 2023 | Ó Donnabháin, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 9547

This annex lists the patent family members relating to the patent documents cited in the above-mentioned European search report.
The members are as contained in the European Patent Office EDP file on
The European Patent Office is in no way liable for these particulars which are merely given for the purpose of information.

25-09-2023

| Patent document cited in search report | Publication date | Patent family member(s) | | Publication date |
|---|---|---|---|---|
| US 2011006766 A1 | 13-01-2011 | CN | 101971045 A | 09-02-2011 |
| | | EP | 2255214 A1 | 01-12-2010 |
| | | JP | 5602030 B2 | 08-10-2014 |
| | | JP | 2011513022 A | 28-04-2011 |
| | | RU | 2010142030 A | 20-04-2012 |
| | | US | 2011006766 A1 | 13-01-2011 |
| | | WO | 2009112987 A1 | 17-09-2009 |
| US 2017045599 A1 | 16-02-2017 | US | 2017045599 A1 | 16-02-2017 |
| | | WO | 2015164606 A1 | 29-10-2015 |
| US 2017234948 A1 | 17-08-2017 | CN | 106574952 A | 19-04-2017 |
| | | EP | 3180629 A1 | 21-06-2017 |
| | | US | 2017234948 A1 | 17-08-2017 |
| | | WO | 2016024024 A1 | 18-02-2016 |
| US 2012172704 A1 | 05-07-2012 | EP | 2063776 A1 | 03-06-2009 |
| | | EP | 2096454 A2 | 02-09-2009 |
| | | JP | 5313899 B2 | 09-10-2013 |
| | | JP | 5762467 B2 | 12-08-2015 |
| | | JP | 5944027 B2 | 05-07-2016 |
| | | JP | 2010501294 A | 21-01-2010 |
| | | JP | 2013176602 A | 09-09-2013 |
| | | JP | 2015126923 A | 09-07-2015 |
| | | US | 2007016003 A1 | 18-01-2007 |
| | | US | 2012172704 A1 | 05-07-2012 |
| | | WO | 2008025146 A1 | 06-03-2008 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011006766 A1